# EUROPÄISCHE PATENTSCHRIFT

(11) **EP 4 256 619 B1**
(45) Veröffentlichungstag und Bekanntmachung des Hinweises auf die Patenterteilung: **29.01.2025**
(21) Anmeldenummer: 21830410.3
(22) Anmeldetag: 03.12.2021
(51) Int. Cl.: H01L 31/0224, H01L 31/0745

(54) **RÜCKSEITENKONTAKTIERTE SOLARZELLE UND HERSTELLUNG EINER SOLCHEN**
BACK-CONTACT SOLAR CELL, AND PRODUCTION THEREOF
CELLULE SOLAIRE À CONTACT ARRIÈRE ET PRODUCTION DE CELLE-CI

(30) Priorität: 04.12.2020 DE 102020132245
(43) Veröffentlichungstag der Anmeldung: 11.10.2023
(73) Patentinhaber: EnPV GmbH, 76131 Karlsruhe (DE)
(72) Erfinder: HOFFMANN, Erik, 70499 Stuttgart (DE)
(74) Vertreter: DREISS Patentanwälte PartG mbB
(86) Internationale Anmeldenummer: PCT/EP2021/084193
(87) Internationale Veröffentlichungsnummer: WO 2022/117826

(56) Entgegenhaltungen:
- CN-U- 209 087 883
- US-A1- 2014 096 821
- US-A1- 2014 338 747
- US-A1- 2017 117 433
- US-A1- 2020 279 968
- US-B2- 10 243 090

## Beschreibung

Die Erfindung betrifft eine Solarzelle und ein Verfahren zum Herstellen einer Solarzelle.

Solarzellen dienen bekanntermaßen als photovoltaische Elemente zur Umwandlung von Licht in elektrische Energie. Ladungsträgerpaare, die bei Absorption von Licht in einem Halbleitersubstrat erzeugt werden, werden am Übergang zwischen einem Emitterbereich, der einen ersten Dotierungstyp, bspw. n-Typ oder p-Typ, zur Erzeugung einer ersten Polarität aufweist, und einem Basisbereich, der einen entgegengesetzten Dotierungstyp zur Erzeugung einer entgegengesetzten Polarität aufweist, getrennt. Über Emitterkontakte, die den Emitterbereich kontaktieren, und Basiskontakte, welche den Basisbereich kontaktieren, können die derart erzeugten und separierten Ladungsträgerpaare einem externen Stromkreis zugeführt werden.

Bekannt sind Solarzellen, bei denen Kontakte einer Polarität an der Vorderseite angeordnet und Kontakte der entgegengesetzten Polarität an der Rückseite angeordnet sind. Als Vorderseite wird die der Sonne zugewandten Seite bezeichnet, die Rückseite bezeichnet entsprechend die abgewandte Seite. Um Verluste, welche aus einer Abschattung durch die auf der Vorderseite angeordneten Kontaktet resultieren, zu minimieren und damit den Wirkungsgrad zu erhöhen, wurden Rückkontaktsolarzellen entwickelt, bei denen beide Kontakttypen, d.h. die Emitterkontakte und die Basiskontakte, auf der Rückseite des Halbleitersubstrats angeordnet sind.

Rückseitenkontaktierte Solarzellen sind beispielsweise bekannt aus US 2020/279968 A1, US 2014/096821 A1, US 2014/338747 A1, CN 209 087 883 U und US 2017/117433 A1. Elektroden der beiden Polaritäten liegen nebeneinander angeordnet auf der Rückseite der Solarzelle. Die generierten Ladungsträger müssen somit auch lateral in der Solarzelle fließen. Um die Widerstandsverluste durch diesen lateralen Stromfluss zu minimieren und zu verhindern, dass die freien Ladungsträger rekombinieren, bevor sie die Elektroden erreichen, sollten die Elektroden der beiden Polaritäten möglichst nah aneinander liegen. Da die Elektroden je nach Polarität entweder mit p- oder n-Typ Silizium verbunden sind, liegen auch die pn-Übergänge möglichst dicht beisammen. Die pn-Übergänge, feine, kammartige Strukturen mit einer Auflösung unter 500 pm, können z.B. mittels Laserbestrahlung realisiert werden. Bei diesem Prozess treibt ein gepulster Laserstrahl zwei unterschiedliche Dotierstoffe, z.B. Bor und Phosphor, durch zeitlich und örtlich getrenntes Aufschmelzen der Oberfläche lokal in das Silizium ein und erzeugt je nach Dotierstoff entweder eine hohe p-Typ oder n-Typ Dotierung. Die ist beispielsweise in der DE 10 2013 219 564 A1 offenbart. Solch feine Strukturen ermöglichen geringe interne Serienwiderstände und Wirkungsgrade η bis η = 24 %. Höhere Wirkungsgrade sind im Wesentlichen durch Rekombinationsmechanismen in der Basis als auch an den hochdotierten kontaktierten und nicht kontaktierten Oberflächen begrenzt. Die Rekombination in der Basis ist abhängig von der Waferqualität und kann nur wenig im weiteren Fertigungsprozess der Solarzelle beeinflusst werden. Die Rekombination an den hochdotieren n- und p-Typ Oberflächen ist im nicht kontaktierten Bereich bei einer guten Oberflächenpassvierung, wie z.B. mit amorphem hydrogeniertem Silizium, durch Augerrekombination begrenzt, welche mit der Dotierstoffkonzentration im Silizium steigt. Im kontaktierten Bereich ist das Silizium in Kontakt mit einem Metall, was eine hohe Grenzflächenrekombination zur Folge hat. Im Solarzellenprozess lässt sich die Augerrekombination an den nicht kontaktierten Oberflächen reduzieren, wenn sich dort möglichst wenig Dotierstoff im Silizium befindet, während die Grenzflächenrekombination an den Metall/Silizium-Kontakten durch eine möglichst kleine Kontaktfläche reduziert werden kann. Allerdings hat eine einfache Reduzierung des Dotierstoffs und der Kontaktflächen eine Steigerung des Serienwiderstands zu Folge, der dann der limitierende Faktor für den Wirkungsgrad wird.

Aus diesem Grund werden passivierte oder auch selektive Kontakte verwendet, beispielsweise bekannt aus DE 10 2013 219 564 A1 oder WO 2014/100004 A1. Die Elektroden sind dabei nicht direkt mit der kristallinen Basis elektrisch verbunden, sondern durch ein dünnes Tunneloxid getrennt, welches die Siliziumoberfläche passiviert aber gleichzeitig so dünn ist, dass die Elektronen je nach Polarität durch das Oxid vom Halbleiter in die Elektrode, bzw. von der Elektrode in den Halbleiter tunneln können. Um die Elektronen zum Tunneln anzuregen, muss sich am Tunneloxid ein elektrisches Feld befinden. Das elektrische Feld kann durch ein hochdotiertes n- oder p-Typ Silizium auf dem Tunneloxid generiert werden. Da die Dotierung dieses Siliziums oberhalb des Tunneloxids zu einer Bandverbiegung in der Siliziumbasis unterhalb des Tunneloxids führt, ist eine höhere Dotierung der Siliziumbasis nicht mehr erforderlich. Am hochdotieren n-Typ Silizium treten nur Elektronen durch das Tunneloxid, auch Elektronenfluss genannt, während am hochdotierten p-Typ Silizium nur ein sogenannter Löcherfluss stattfindet: Elektronen treten aus dem hochdotierten p-Typ Silizium in die Siliziumbasis ein. Die Metallelektroden selbst stehen nur noch in elektrischem und mechanischem Kontakt zu dem hochdotierten n- oder p-Typ Silizium oberhalb des Tunneloxids. Die Selektivität der hochdotierten Siliziumbereiche in Kombination mit dem Tunneloxid sorgt, abhängig von der Dotierung, für den Transport fast ausschließlich einer Art der Ladungsträger an die Metall/Silizium-Kontaktflächen und minimiert die Grenzflächenrekombination. Die vorgestellte Struktur senkt weiter die Augerrekombination an der Oberfläche der Siliziumbasis zum Tunneloxid, da an dieser Grenzfläche keine hohe Dotierung für den pn-Übergang oder den ohmschen Kontakt zu der Basis erforderlich ist.

Rückseitenkontaktsolarzellen mit passivierten Kontakten erreichten bisher einen Rekordwirkungsgrad von η = 26,7 %. Die Herstellung solcher Zellen ist bisher jedoch sehr aufwendig, da die beiden unterschiedlich dotieren selektiven Kontakte nur mit diversen aufwendigen Maskierungs- und Strukturierungsschritten aufgebracht werden können. Dabei muss auf eine hohe Präzision und feine Auflösung der Maskierung/Strukturierung geachtet werden. Der Abstand der selektiven Kontakte darf nicht zu groß sein und sollte die Diffusionslänge der freien Ladungsträger nicht übersteigen und auch nicht zu einem Anstieg des internen Serienwiderstands aufgrund des lateralen Stromflusses in der Basis führen.

Diese Nachteile werden durch eine erfindungsgemäße Solarzelle und ein erfindungsgemäßes Verfahren zum Herstellen einer solchen Solarzelle überwunden. Gleichzeitig wird durch das erfindungsgemäße Verfahren eine industrielle Fertigung mit niedrigen Prozesskosten ermöglicht.

Erfindungsgemäß wird eine rückseitenkontaktierte Solarzelle gemäß Anspruch 1 vorgeschlagen. Die rückseitenkontaktierte Solarzelle umfasst ein Halbleitersubstrat, insbesondere einen Siliziumwafer, umfassend eine Vorderseite und eine Rückseite, wobei die Solarzelle auf der Rückseite Elektroden einer ersten Polarität und Elektroden einen zweiten Polarität umfasst, vorgeschlagen, dass die Elektroden der ersten Polarität auf einer hochdotierte Siliziumschicht der ersten Polarität angeordnet sind, wobei die hochdotierte Siliziumschicht auf einer auf dem Halbleitsubstrat angeordneten ersten Passivierschicht angeordnet ist, und die Elektroden der zweiten Polarität das Halbleitersubstrat über hochdotierte Basisbereiche der zweiten Polarität des Halbleitersubstrats direkt elektrisch und mechanisch kontaktieren.

Es wird also vorgeschlagen, für die Elektroden der ersten Polarität und für die Elektroden der zweiten Polarität ein unterschiedliches Kontaktierungskonzept zu verwenden, sodass bei der erfindungsgemäß vorgeschlagenen rückseitenkontaktierten Solarzelle beide Kontaktierungskonzepte kombiniert werden. Für die Elektroden der ersten Polarität wird vorgeschlagen, dass diese die hochdotierte Siliziumschicht, die auf einer Passivierschicht, auch als Tunnelschicht bezeichnet, abgeschieden ist, kontaktieren. Für die Elektroden der zweiten Polarität wird vorgeschlagen, dass diese das Halbleitersubstrat direkt kontaktieren. Dies erfordert bei der Herstellung eine Maskierung und Demaskierung.

Es ist vorgesehen, dass die hochdotierten Basisbereiche der zweiten Polarität innerhalb dotierter Basisbereiche der zweiten Polarität auf der Rückseite der Solarzelle ausgebildet sind, wobei eine Dotierstoffkonzentration in den hochdotierten Basisbereichen höher ist, als eine Dotierstoffkonzentration in den dotierten Basisbereichen, und wobei die Dotierstoffkonzentration in den hochdotierten Basisbereichen höher ist als eine Dotierstoffkonzentration eines dotierten Bereichs auf der Vorderseite der Solarzelle. Die dotierten Basisbereiche auf der Rückseite weisen eine Dotierstoffkonzentration an der Oberfläche von 1×10¹⁷ cm⁻³ bis 1×10¹⁹ cm⁻³ auf. Die Dotierung auf der gesamten Vorderseite kann ebenfalls eine Dotierstoffkonzentration an der Oberfläche von 1×10¹⁷ cm⁻³ bis 1×10¹⁹ cm⁻³ umfassen. Die Dotierstoffkonzentration der hochdotierten Basisbereiche für den Basiskontakt liegt an der Oberfläche vorzugsweise über einer Dotierstoffkonzentration von 2×10¹⁹ cm⁻³.

Gemäß einer Ausführungsform ist vorgesehen, dass auf Oberflächenbereichen der Rückseite, die nicht durch die Elektroden der ersten Polarität und nicht durch die Elektroden der zweiten Polarität kontaktiert sind eine zweite Passivierschicht angeordnet ist. Die zweite Passivierschicht ist dabei dicker als die erste Passivierschicht. Der Bereich zwischen zwei Elektroden unterschiedlicher Polarität umfasst Bereiche in denen die zweite Passivierschicht und Bereiche in denen ein Schichtstapel umfassend die erste und die zweite Passivierschicht angeordnet ist.

Die Oberfläche der erfindungsgemäßen Solarzelle umfasst also die folgenden unterschiedlich dotierten Bereiche:
- eine hochdotierte polykristalline Siliziumschicht der ersten Polarität auf der Rückseite der Solarzelle auf der auf dem Halbleitsubstrat angeordneten ersten Passivierschicht, wobei die Dotierstoffkonzentration der hochdotierten polykristallinen Siliziumschicht höher ist als die Dotierstoffkonzentration der Basis;
- dotierte monokristalline Basisbereiche der zweiten Polarität auf der Rückseite, wobei die Dotierstoffkonzentration der dotierten Basisbereiche höher ist als die Dotierstoffkonzentration der Basis;
- hochdotierte monokristalline Basisbereiche der zweiten Polarität innerhalb der dotierten Basisbereiche auf der Rückseite, wobei die Dotierstoffkonzentration dieser hochdotierten Basisbereiche höher ist als die Dotierstoffkonzentration der Basis und die Dotierstoffkonzentration der dotierten Basisbereiche.
- eine dotierte monokristalline Oberfläche einer ersten oder zweiten Polarität auf der gesamten Vorderseite, wobei die Dotierstoffkonzentration der dotierten Oberfläche höher ist als die Dotierstoffkonzentration der Basis.

Weitere Ausführungsformen betreffen ein Verfahren zum Herstellen einer rückseitenkontaktierten Solarzelle gemäß den vorstehend beschriebenen Ausführungsformen.

Ein Halbleitersubstrat der Solarzelle umfasst eine, insbesondere polierte oder texturierte, Rückseite und eine, insbesondere texturierte, Vorderseite. Das Texturieren erfolgt beispielsweise durch eine nasschemische Lösung. Auf einer Oberfläche der Rückseite und/oder auf einer Oberfläche der Vorderseite wird eine erste Passivierschicht, insbesondere umfassend Siliziumdioxid, aufgebracht. Die erste Passivierschicht umfasst beispielsweise eine Dicke von vorzugsweise maximal 4 nm. Die erste Passivierschicht wird beispielsweise in einem thermischen oder nasschemischen Prozess oder durch Deposition hergestellt.

Gemäß einer Ausführungsform umfasst das Verfahren weiter einen Schritt zum Abscheiden einer, insbesondere vollflächigen, hochdotierten Siliziumschicht einer ersten Polarität auf der ersten Passivierschicht auf der Rückseite und/oder auf der Vorderseite. Die Abscheidung der hochdotierten Siliziumschicht der ersten Polarität kann beispielsweise mittels plasmaunterstützter chemischer Gasphasenabscheidung, PECVD, atmosphärischer chemischer Gasphasenabscheidung, APCVD, chemischer Niederdruck-Gasphasenabscheidung, LPCVD, oder Kathodenzerstäubung erfolgen. Die hochdotierte Siliziumschicht der ersten Polarität weist eine Dicke von ca. 50 nm bis 400 nm auf. Die Dotierstoffkonzentration der hochdotierten Siliziumschicht ist höher als die Dotierstoffkonzentration des Halbleitersubstrats. Der insitu abgeschiedene Dotierstoff in der Siliziumschicht ist zum Beispiel Bor, Aluminium oder Gallium.

Die Abscheidung der hochdotierten Siliziumschicht der ersten Polarität kann statt in einem auch in zwei Schritten erfolgen. In diesem Fall wird zunächst undotiertes Silizium abgeschieden und anschließend ein Dotierstoff eingebracht. Das Einbringen des Dotierstoffes erfolgt beispielsweise mittels Ionenimplantation oder dem Aufbringen einer Dotierstoffquelle und der anschließenden Eindiffusion mittels eines thermischen Prozesses oder Laserdiffusion. Bei dem Dotierstoff handelt es sich beispielweise um Bor, Aluminium oder Gallium. Die Eindiffusion kann auch erst zu einem späteren Zeitpunkt erfolgen. Beispielsweise kann das Verfahren noch einen späteren Schritt zum Einbringen eines weiteren Dotierstoffs umfassen. In diesem Fall kann das Eindiffundieren der Dotierstoffe gleichzeitig mit dem Eindiffundieren des zweiten Dotierstoffes in einem gemeinsamen thermischen Prozess erfolgen.

Gemäß einer Ausführungsform ist vorgesehen, dass eine dielektrische Schicht auf der Rückseite aufgebracht wird.

Die dielektrische Schicht umfasst beispielsweise Siliziumnitrid, Siliziumoxid, Siliziumcarbid oder Aluminiumoxid. Die dielektrische Schicht dient als sogenannte Diffusionsbarriere gegen einen später aufzubringenden Dotierstoff, beispielsweise Phosphor, und besitzt ätzresistente Eigenschaften gegen eine später aufzubringende nasschemische Lösung. Die dielektrische Schicht umfasst beispielsweise eine größere Dicke als die erste Passivierschicht, vorzugsweise eine Dicke von mehr als 4 nm.

Gemäß einer Ausführungsform ist vorgesehen, dass durch lokales Entfernen der dielektrischen Schicht, und der hochdotierten Siliziumschicht der ersten Polarität und der ersten Passivierschicht auf der Rückseite Basisbereiche des Halbleitersubstrats auf der Rückseite freigelegt werden. Das Entfernen der einzelnen Schichten erfolgt beispielsweise zumindest teilweise durch Laserbestrahlung. Gemäß einer Ausführungsform ist vorgesehen, dass in den Basisbereichen des Halbleitersubstrats auf der Rückseite lokal ein Teil des Halbleitersubstrats entfernt wird. Dies kann ebenfalls durch Laserbestrahlung erfolgen.

Gemäß einer Ausführungsform ist vorgesehen, dass das Freilegen der Basisbereiche des Halbleitersubstrats auf der Rückseite ein Ätzen der hochdotierten Siliziumschicht der ersten Polarität und/oder der ersten Passivierschicht und/oder eines Teils des Halbleitersubstrats lokal in den Basisbereichen umfasst. Beispielsweise kann vorgesehen sein, dass eine nasschemische Lösung an den zuvor laserbestrahlten Basisbereichen die hochdotierte Siliziumschicht, die erste Passivierschicht und einen Teil des Halbleitersubstrats ätzt. Alternativ kann vorgesehen sein, dass die nasschemische Lösung nur die hochdotierte Siliziumschicht oder nur einen Teil des Halbleitersubstrats ätzt. In diesem Fall werden die anderen Schichten, beispielsweise die erste Passivierschicht oder die die hochdotierte Siliziumschicht, durch Laserbestrahlung entfernt. Vorteilhafterweise kann durch die nasschemische Lösung auch eine gegebenenfalls auf der Vorderseite des Halbleitersubstrats abgeschiedene hochdotierte Siliziumschicht und/oder eine auf der Vorderseite des Halbleitersubstrats abgeschiedene Passivierschicht geätzt werden.

Es kann vorgesehen sein, dass das Ätzen ein isotropes Ätzen zum Polieren von Bereichen und/oder dass das Ätzen ein anisotropes Ätzen zum Texturieren von Bereichen umfasst. Beispielsweise können durch isotropes Ätzen mit einer nasschemischen Lösung auf der Rückseite die Basisbereiche poliert werden. Alternativ können durch anisotropes Ätzen mit einer nasschemischen Lösung auf der Rückseite die Basisbereiche texturiert werden. Es kann auch vorteilhaft sein, wenn durch anisotropes Ätzen mit einer nasschemischen Lösung die Vorderseite texturiert wird. Für das Entfernen der unterschiedlichen Schichten und gegebenenfalls dem Texturieren und/oder Polieren der Oberflächen können unterschiedliche nasschemische Lösungen verwendet werden. Gemäß einer Ausführungsform ist vorgesehen, dass das Verfahren einen Schritt zum Anbringen einer Precursorschicht umfassend einen Dotierstoff, insbesondere Phosphor, auf der Rückseite oder auf der Rückseite und auf der Vorderseite, umfasst. Die Precursorschicht kann auf der Vorderseite und auf der Rückseite in einem Verfahrensschritt oder in unterschiedlichen Verfahrensschritten abgeschieden werden. Die Precursorschichten auf Vorder- und Rückseite können dieselben oder unterschiedliche Eigenschaften aufweisen. Bei der Precursorschicht handelt es sich um eine Schicht umfassend einen Dotierstoff einer zweiten Polarität, insbesondere eine Phosphorsilikatglasschicht, PSG. Die Precursorschicht wird insbesondere auf der dielektrischen Schicht und auf, insbesondere den nasschemisch geätzten, Bereichen auf der Rückseite und auf der Vorderseite aufgebracht. Wenn es sich bei der hochdotierten Siliziumschicht der ersten Polarität um eine p-Typ Siliziumschicht handelt, handelt es sich bei dem Dotierstoff in der Precursorschicht für das Dotieren des Siliziums gemäß der zweiten Polarität beispielsweise um Phosphor. Zum Aufbringen der Precursorschicht kann beispielsweise ein Ofendiffusionsprozess gefahren werden, bei dem eine Phosphorsilikatglasschicht auf den vorher geätzten Bereichen auf der Rückseite und auf der Vorderseite wächst. In besonderen Fällen kann die PSG-Schicht auch auf der dielektrischen Schicht auf der Rückseite wachsen. Der Ofendiffusionsprozess kann so gefahren werden, dass nach dem Ofendiffusionsprozess in der Phosphorsilikatglasschicht ein hoher Anteil an Phosphor enthalten ist. In einer weiteren Ausführungsform kann die Precursorschicht, beispielsweise PSG, zum Beispiel mittels PECVD, LPCVD oder APCVD abgeschieden werden.

Gemäß einer Ausführungsform ist vorgesehen, dass durch einen Hochtemperaturschritt, in dem der Dotierstoff aus der Precursorschicht in die Basisbereiche auf der Rückseite und/oder in die Oberfläche der Vorderseite diffundiert, die Dotierung in den Basisbereichen auf der Rückseite erhöht wird und/oder ein dotierter Bereich auf der Vorderseite erzeugt wird. Der Dotierstoff dotiert die Basisbereiche auf der Rückseite gemäß einer zweiten Polarität, entgegengesetzt der ersten Polarität der hochdotierten Siliziumschicht, sodass dotierte Basisbereiche erzeugt werden. Die dotierten Basisbereiche auf der Rückseite umfassen eine höhere Dotierstoffkonzentration als die Dotierstoffkonzentration des Halbleitersubstrats. Auf der Rückseite diffundiert der Dotierstoff aus der Precursorschicht nicht in die hochdotierte Siliziumschicht, da die dielektrische Schicht als Diffusionsbarriere gegen den Dotierstoff aus der Precursorschicht dient. Auf der Vorderseite wird durch die Dotierung der Oberfläche gemäß der zweiten Polarität ein dotierter Bereich auf der Vorderseite erzeugt. Die Dotierstoffkonzentration des dotierten Bereichs auf der Vorderseite ist höher als die Dotierstoffkonzentration des Halbleitersubstrats. Bei dem Hochtemperaturschritt handelt es sich beispielsweise um den Ofendiffusionsschritt zum Aufbringen der Precursorschicht.

Alternativ kann es sich auch um einen zusätzlichen Hochtemperaturschritt handeln.

Der Hochtemperaturschritt kann beispielsweise so gefahren werden, dass nur ein Teil des zweiten Dotierstoffes aus der Precursorschicht in die Basisbereiche auf der Rückseite diffundiert.

Gemäß einer Ausführungsform ist vorgesehen, dass innerhalb der Basisbereiche auf der Rückseite ein hochdotierter Basisbereich erzeugt wird, durch lokale Erhöhung der Dotierstoffkonzentration, insbesondere durch Laserbestrahlung. Durch die Laserbestrahlung wird die Oberfläche auf der Rückseite in den bestrahlten Bereichen lokal erhitzt und aufgeschmolzen. Weiterer Dotiersoff aus der Precursorschicht diffundiert in den bestrahlten Bereichen in die Oberfläche und dotiert, nach Abkühlen und Rekristallisation, den bestrahlen Bereich weiter gemäß der zweiten Polarität, sodass hochdotierte Basisbereiche erzeugt werden. Die Dotierstoffkonzentration in den hochdotierten Basisbereichen ist signifikant höher als die Dotierstoffkonzentration des Halbleitersubstrats, höher als die der dotierten Basisbereiche auf der Rückseite und höher als die in dem dotierten Bereich auf der Vorderseite. Durch das Erzeugen der hochdotierten Basisbereiche durch Laserbestrahlung kann vorteilhafterweise im vorhergehenden Schritt der Ofendiffusion eine insbesondere auf die Vorderseite der Solarzelle optimierte Dotierung erzeugt werden. Die Vorderseite ist idealerweise niedriger dotiert als die Basisbereiche auf der Rückseite. Werden Vorder- und Rückseite in nur einem gemeinsamen Prozessschritt dotiert, ist ein Kompromiss der Dotierung erforderlich. Dieser Nachteil wird durch das Erzeugen der hochdotierten Basisbereiche auf der Rückseite mittels Laserbestrahlung überwunden.

Gemäß einer Ausführungsform ist vorgesehen, dass das Verfahren einen Schritt zum Entfernen der Precursorschicht, insbesondere Phosphorsilikatglas, von der Vorderseite und/oder von der Rückseite umfasst. Das Entfernen erfolgt beispielsweise in einem nasschemischen Reinigungsschritt. Vorteilhafterweise werden durch den nasschemischen Reinigungsschritt oder durch einen weiteren nachchemischen Reinigungsschritt auch verbliebene Reste der dielektrischen Schicht von der hochdotierten Siliziumschicht entfernt. Gemäß einer Ausführungsform ist vorgesehen, dass das Verfahren einen Schritt zum Aufbringen einer zweiten Passivierschicht auf der Rückseite und/oder einer dritten Passivierschicht auf der Vorderseite umfasst. Eine Passivierschicht umfasst beispielsweise Siliziumdioxid Siliziumnitrid, Aluminiumoxid oder einen Schichtstapel aus zwei oder mehreren dielektrischen Schichten. Dabei kann sich die Dicke, Brechungsindex und Zusammensetzung der Passivierschicht auf der Rückseite von Dicke, Brechungsindex und Zusammensetzung der Passivierschicht auf der Vorderseite unterscheiden. Die Dicken der Passivierschichten sind vorteilhafterweise so optimiert, dass die Reflexion auf der Vorderseite verringert und auf der Rückseite erhöht wird. Die zweite und/oder dritte Passivierschicht umfasst vorteilhafterweise eine größere Dicke als die erste Passivierschicht. Die Dicke der zweiten und/oder dritten Passivierschicht ist vorteilhafterweise größer als 4 nm.

Gemäß einer Ausführungsform ist vorgesehen, dass das Verfahren einen Schritt zum selektiven Entfernen der zweiten Passivierschicht auf der Rückseite umfasst. Die Passivierschicht kann lokal, beispielsweise durch Laserbestrahlung, entfernt werden.

Gemäß einer Ausführungsform ist vorgesehen, dass das Verfahren einen Schritt zum Aufbringen von Elektroden einer ersten Polarität und Elektroden einer zweiten Polarität auf der Rückseite der Solarzelle umfasst. Das Aufbringen der Elektroden kann beispielsweise mittels Siebdruck, Aufdampfen, Sputtern oder galvanischer Abscheidung eines oder mehrerer Metallen oder anderer leitfähiger Schichten erfolgen. Die Elektroden können beispielsweise Silberpaste, Silber/Aluminium-Paste, Aluminiumpaste oder reines Aluminium, Kupfer, Zinn, Palladium, Silber, Titan, Nickel oder Schichtstapel oder Legierungen der genannten Metalle oder andere leitfähige Schichten, insbesondere leitfähige Polymere oder Oxide, oder eine Kombination solcher Schichten mit Metallen umfassen. Die Zusammensetzung und der Abscheidungsprozess der Elektroden kann sich für die Elektroden der beiden Polaritäten unterscheiden. Vorzugsweise kontaktieren die Elektroden der zweiten Polarität nur die hochdotierten Basisbereiche und nicht die dotierten Basisbereiche.

Ebenfalls Gegenstand dieser Erfindung ist eine Solarzelle und ein Verfahren zum Herstellen einer Solarzelle, bei der die beschriebenen Polaritäten jeweils eine entgegensetzte Polarität zu den beschriebenen Polaritäten umfassen. Die Solarzelle umfasst dann beispielsweise eine p-Typ dotierte Basis, entsprechend einen n-Typ dotierten Emitter und wiederum eine p-Typ Basisdotierung der Oberflächen. Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung.

In der Zeichnung zeigt:
Fig. 1 eine schematische Ansicht eines Ausschnitts einer erfindungsgemäßen Solarzelle, und
Fig. 2a bis 2h zeigen eine Solarzelle gemäß Figur 1 in verschiedenen Schritten eines Verfahrens zur Herstellung der Solarzelle.

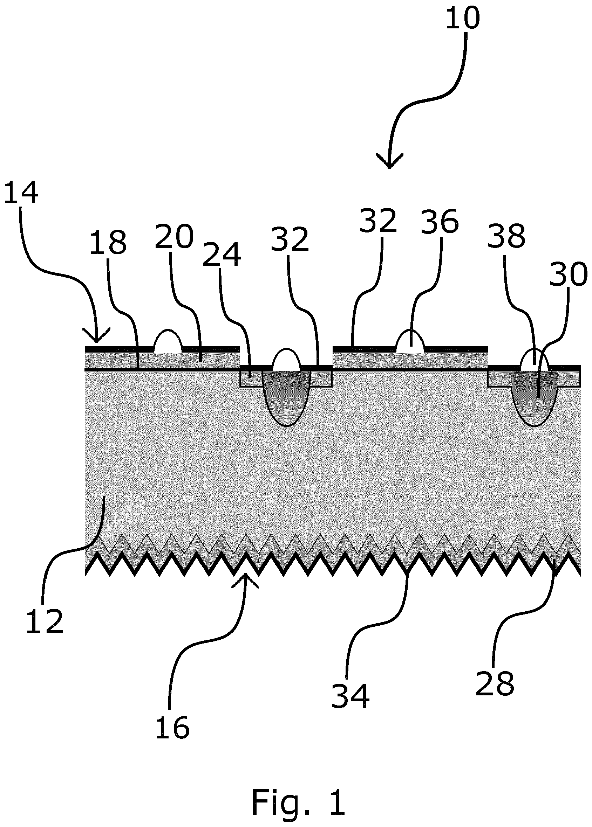

Figur 1 zeigt einen Ausschnitt einer Solarzelle 10 mit einem Halbleitersubstrat 12, insbesondere einem Siliziumwafer, einer Rückseite 14 und einer im Betrieb der Solarzelle der Sonne zugewandten Vorderseite 16. Der Siliziumwafer 12 kann entweder n- oder p-Typ dotiert sein. Die Solarzelle 10 wird beispielhaft anhand einer n-Typ Dotierung des Siliziumwafers 12, der "Basis", erläutert.

Die Vorderseite 16 der Solarzelle 10 ist vorzugsweise texturiert. Die Rückseite 14 der Solarzelle 10 kann, insbesondere in verschiedenen Bereichen unterschiedlich, poliert oder texturiert sein.

Auf der Rückseite 14 ist eine polykristalline hochdotierte p-Typ Siliziumschicht 20 vorgesehen. Diese bildet eine erste Polarität mit einer ersten Dotierstoffkonzentration auf der Rückseite 14. Im Bereich der hochdotierten p-Typ Siliziumschicht 20 passiviert eine erste Passivierschicht 18, insbesondere umfassend Siliziumdioxid, die Oberfläche des Siliziumwafers 12. Des Weiteren sind dotierte Basisbereiche 24 einer zweiten, der ersten Polarität entgegengesetzten, Polarität vorgesehen. Die dotierten Basisbereiche 24 auf der Rückseite 14 weisen die gleiche Polarität aber eine höhere Dotierstoffkonzentration als das Halbleitersubstrat 12 auf.

Auf der Vorderseite 16 befindet sich ein dotierter Bereich 28. Der dotierte Bereich 28 weist ebenfalls die gleiche Polarität aber eine höhere Dotierstoffkonzentration als das Halbleitersubstrat 12.

Innerhalb der dotierten Basisbereiche 24 auf der Rückseite sind hochdotierte Basisbereiche 30 ausgebildet. Die hochdotierten Basisbereiche weisen ebenfalls die zweite Polarität, jedoch eine signifikant höhere Dotierstoffkonzentration als das Halbleitersubstrat 12, als die dotierten Basisbereiche 24 und als der dotierte Bereich 28 auf.

Die Solarzelle 10 umfasst weiter eine zweite Passivierschicht 32 auf der Rückseite 14 und eine dritte Passivierschicht 34 auf der Vorderseite 16. Die Passivierschicht 32 bedeckt zumindest teilweise die hochdotierte Siliziumschicht 20, die dotierten Basisbereiche 24 und die hochdotierten Basisbereiche 30, in den, nicht durch Elektroden 36, 38 kontaktierten, Bereichen. Die zweite Passivierschicht 32, beispielsweise durch eine dielektrische Schicht oder Schichtstapel gebildet, umfasst vorzugsweise eine größere Dicke als die erste Passivierschicht 18, vorzugsweise eine Dicke von mehr als 4 nm. Die zweite Passivierschicht 32 kann beispielweise aus Siliziumdioxid, Siliziumnitrid oder Aluminiumoxid, oder aus einem Schichtstapel dieser Schichten bestehen. Die Dicken und Brechungsindizes der Passivierschicht 32 können so optimiert sein, dass möglichst viel elektromagnetische Strahlung, die nicht durch die Solarzelle absorbiert wurde, an der Rückseite zurück in die Solarzelle reflektiert wird. Die dritte Passivierschicht 34 auf der Vorderseite 16 umfasst vorzugsweise ebenfalls eine größere Dicke als die erste Passivierschicht 18, vorzugsweise eine Dicke von mehr als 4nm. Die dritte Passivierschicht 34 kann beispielweise aus Siliziumdioxid, Siliziumnitrid oder Aluminiumoxid, oder aus einem Schichtstapel dieser Schichten bestehen. Die Dicken und Brechungsindizes der dritte Passivierschicht 34 können so optimiert sein, dass möglichst viel auf der Vorderseite 16 einfallende elektromagnetische Strahlung nicht reflektiert und absorbiert wird.

Die Solarzelle 10 umfasst auf der Rückseite 14 Elektroden 36 einer ersten Polarität und Elektroden 38 einer zweiten Polarität. Die Elektroden 36 der ersten Polarität kontaktieren die hochdotierte Siliziumschicht 20 der ersten Polarität, die auf der ersten Passivierschicht 18 abgeschieden ist. Vorteilhafterweise durchdringen die Elektroden 36 die erste Passivierschicht 18 nicht. Es kann jedoch vorkommen, dass die Elektroden 36 die erste Passivierschicht 18 teilweise durchdringen und das Halbleitersubstrat 12 kontaktieren. Die Elektroden 38 der zweiten Polarität kontaktierten das Halbleitersubstrat 12 direkt elektrisch und mechanisch in den dotierten Basisbereichen 24, vorzugsweise nur in den hochdotierten Bereichen 30 der dotierten Basisbereiche 24.

Von den Elektroden 36, 38 nicht kontaktierte Bereiche können entweder durch den Schichtstapel aus der ersten Passivierschicht 18 und hochdotierter Siliziumschicht 20 der ersten Polarität, oder von der zweiten Passivierschicht 32 in den dotierten Basisbereichen 24 und hochdotierten Basisbereichen 30 bedeckt und passiviert sein. Die zweite Passivierschicht 32 kann auch die hochdotierte Siliziumschicht 20 in den nicht kontaktierten Bereichen bedecken.

Vorzugsweise entspricht die durch die Elektroden 36 der zweiten Polarität elektrisch kontaktierte Fläche den Flächen der hochdotierten Basisbereiche 30 der zweiten Polarität.

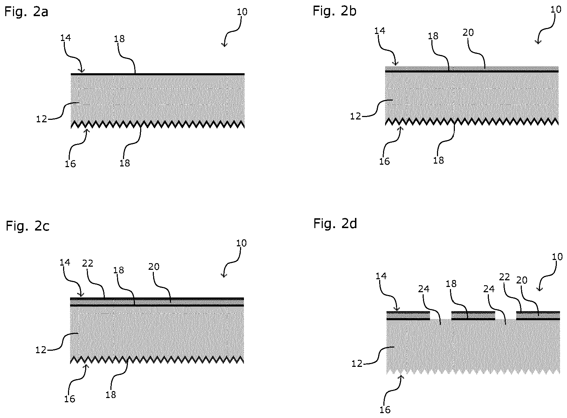

Der Herstellungsprozess der Solarzelle 10 wird im Weiteren anhand der Figuren 2a bis 2h erläutert. Die Figuren 2a bis 2h illustrieren den Prozessablauf für die Fertigung einer rückseitenkontaktierten Solarzelle 10 mit einem passivierten Kontakt im Bereich der hochdotierten Siliziumschicht 20 und einem diffundierten Kontakt im Bereich der hochdotierten Basisbereiche 30. Als Ausgangsmaterial kann das Halbleitersubstrat 12 n- oder p-Typ dotiert sein. Der Prozessablauf wird anhand einer n-Typ Dotierung des Wafers, der "Basis", erläutert.

Figur 2a zeigt die Ausgangsform des Siliziumwafers 12 mit einer polierten Rückseite 14 und einer texturierten Vorderseite 16. Gemäß einer weiteren nicht dargestellten Ausgangsform können Vorder- und Rückseite entweder beide poliert oder beide texturiert vorliegen. Gemäß der dargestellten Ausführungsform wird auf der Vorderseite 16 und auf der Rückseite 14 eine erste Passivierschicht 18, z.B. ein Siliziumdioxid, mit einer Dicke von vorzugsweise maximal etwa 4 nm, beispielsweise in einem thermischen oder nasschemischen Prozess oder durch Deposition, hergestellt. Alternativ kann die kann die Abscheidung gemäß einer weiteren nicht dargestellten Ausführungsform der ersten Passivierschicht nur auf der Rückseite 14 erfolgen.

In einem nächsten Schritt, vgl. Figur 2b, wird eine, insbesondere vollflächige, hochdotierte Siliziumschicht 20 einer ersten Polarität auf der Tunnelschicht 18 auf der Rückseite 14 abgeschieden. Im Weiteren wird von einer p-Typ Dotierung als erste Polarität der hochdotierten Siliziumschicht ausgegangen. Die Abscheidung der hochdotierten p-Typ Siliziumschicht 20 kann beispielsweise mittels plasmaunterstützter chemischer Gasphasenabscheidung, PECVD, atmosphärischer chemischer Gasphasenabscheidung, APCVD, chemischer Niederdruck-Gasphasenabscheidung (LPCVD) oder Kathodenzerstäubung erfolgen. Die hochdotierte p-Typ Siliziumschicht 20 weist eine Dicke von ca. 50 nm bis 400 nm auf. Gemäß einer weiteren nicht dargestellten Ausführungsform kann die Abscheidung der hochdotierten Siliziumschicht auch beidseitig auf Vorder- und Rückseite erfolgen.

Das Abscheiden der hochdotierten p-Typ Siliziumschicht 20 kann statt in einem auch in zwei Schritten erfolgen. In diesem Fall umfasst das Abscheiden der p-Typ Siliziumschicht 20 das Abscheiden von undotiertem Silizium und anschließendes Einbringen eines Dotierstoffs. Das Einbringen des Dotierstoffs erfolgt beispielsweise mittels Ofendiffusion oder Laserdiffusion aus einer auf der Siliziumschicht aufgebrachten Dotierquelle oder mittels Ionenimplantation. Bei dem Dotierstoff handelt es sich beispielweise um Bor, Aluminium oder Gallium.

In einem nächsten Schritt des Verfahrens, vgl. Figur 2c, wird eine dielektrische Schicht 22 auf der Rückseite 14 auf der hochdotierten Siliziumschicht 20 abgeschieden. Die Schichtabscheidung erfolgt nur auf der Rückseite 14. Eine parasitäre Abscheidung auf der Vorderseite 16 ist nicht ganz auszuschließen. Die Abscheidung der dielektrischen Schicht 22 erfolgt z.B. mittels PECVD, APCVD, LPCVD oder PVD. Die dielektrische Schicht 22 weist eine größere Dicke als die erste Passivierschicht 18 auf und ist somit dicker als 4 nm.

Figur 2d zeigt einen weiteren Verfahrensschritt, das Freilegen von Basisbereichen 24 des Halbleitersubstrats 12 auf der Rückseite 14 durch lokales Entfernen der dielektrischen Schicht 22, der hochdotierte Siliziumschicht 20 der ersten Polarität und der ersten Passivierschicht 18. Weiter ist das Entfernen der Passivierschicht 18 auf der Vorderseite 16 dargestellt. In einer weiteren nicht dargestellten Ausführungsform kann auch ein Entfernen einer Siliziumschicht auf der Vorderseite 16 erforderlich sein. Das Freilegen der Basisbereiche 24 erfolgt beispielsweise durch lokales Entfernen der dielektrischen Schicht 22 durch Laserbestrahlung. Denkbar ist auch, dass die zweite dielektrische Schicht 22 nicht gänzlich entfernt wird.

Die hochdotierte Siliziumschicht 20, die erste Passivierschicht 18 und gegebenenfalls ein Teil des Halbleitersubstrats 12 können ebenfalls zumindest teilweise lokal durch Laserbestrahlung entfernt werden.

Alternativ kann die hochdotierte Siliziumschicht 20 und/oder die erste Passivierschicht 18 teilweise lokal durch eine nasschemische Lösung geätzt werden. Die dielektrische Schicht 22 wurde vorteilhafterweise so gewählt, dass die nasschemische Lösung die dielektrische Schicht 22 nicht ätzt, oder wesentlich langsamer als die hochdotierte Siliziumschicht 20 und die erste Passivierschicht 18. Je nachdem welche Schichten vorhergehend bereits durch Laserbestrahlung entfernt wurden, ätzt die nasschemische Lösung gegebenenfalls auch verbliebene Reste der dielektrischen Schicht 22, die erste Passivierschicht 18 auf Vorderseite 16 und gegebenenfalls ein Teil des Halbleitersubstrats auf Vorderseite 16 und Rückseite 14. Alternativ kann die erste Passivierschicht 18 auch als Ätzbarriere dienen, sodass die erste Passivierschicht und das Halbleitersubstrat 12 nicht geätzt werden. Für den Fall, dass sich auf der Vorderseite 16 auch die hochdotierte Siliziumschicht befindet, wird diese in einer weiteren nicht dargestellten Ausführungsform ebenfalls geätzt.

Es kann vorgesehen sein, dass das Ätzen ein isotropes Ätzen zum Polieren von Bereichen und/oder dass das Ätzen ein anisotropes Ätzen zum Texturieren von Bereichen umfasst. Beispielsweise können durch isotropes Ätzen mit einer nasschemischen Lösung auf der Rückseite 14 die Basisbereiche 24 poliert werden. Alternativ können durch anisotropes Ätzen mit einer nasschemischen Lösung auf der Rückseite 14 die Basisbereiche 24 texturiert werden. Es kann auch vorteilhaft sein, wenn durch anisotropes Ätzen mit einer nasschemischen Lösung die Vorderseite 16 texturiert wird. Für das Entfernen und gegebenenfalls Texturieren und/oder Polieren der unterschiedlichen Schichten und Oberflächen können unterschiedliche nasschemische Lösungen verwendet werden.

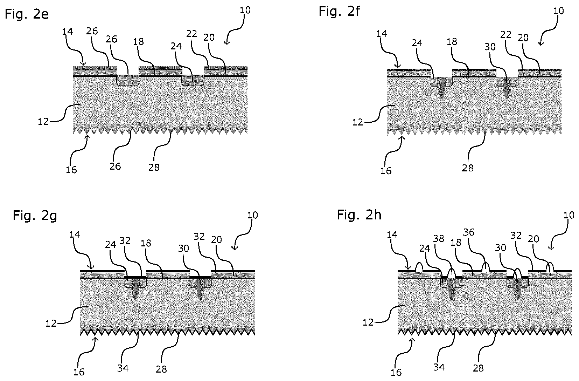

In Figur 2e ist die Deposition einer Precursorschicht 26 auf der gesamten Rückseite 14 und der gesamten Vorderseite 16 der Solarzelle 10 dargestellt. Die Deposition auf Vorderseite 16 und Rückseite 14 erfolgt beispielsweise gleichzeitig. Die Precursorschichten 26 auf Vorderseite 16 und Rückseite 14 können unterschiedliche Eigenschafften, beispielsweise hinsichtlich der Dicke oder einer in der Precursorschicht 26 enthaltenen Dotierstoffmenge, umfassen. Auf der Rückseite kann die Precursorschicht 26 auf den unterschiedlichen Oberflächen, der dielektrischen Schicht 22 beziehungsweise dem freigelegten Basisbereich 24 unterschiedlich abgeschieden werden und somit unterschiedliche Eigenschaften aufweisen. Bei der Precursorschicht 26 handelt es sich um eine Schicht umfassend einen Dotierstoff einer zweiten Polarität, insbesondere eine Phosopohrsilikatglasschicht, PSG. Zum Aufbringen der Precursorschicht 26 kann beispielsweise ein Ofendiffusionsprozess gefahren werden, bei dem eine Phosphorsilikatglasschicht auf der hochdotierten Siliziumschicht 20 auf der Rückseite 14 und auf der Vorderseite 16 wächst. Der Ofendiffusionsprozess kann so gefahren werden, dass nach dem Ofendiffusionsprozess in der Phosphorsilikatglasschicht ein hoher Anteil an Phosphor enthalten ist. Alternativ kann die Precursorschicht 26, beispielsweise PSG, zum Beispiel mittels PECVD, LPCVD oder APCVD abgeschieden werden.

In einem Hochtemperaturschritt, in dem der Dotierstoff aus der Precursorschicht 26 in die Basisbereiche 24 auf der Rückseite 14 und/oder in die Oberfläche der Vorderseite 16 diffundiert, wird die Dotierung in den Basisbereichen 24 auf der Rückseite 14 erhöht und ein dotierter Bereich 28 auf der Vorderseite 16 erzeugt. Der Dotierstoff dotiert die Basisbereiche 24 auf der Rückseite 14 gemäß einer zweiten Polarität, entgegengesetzt der ersten Polarität der hochdotierten Siliziumschicht 20, sodass dotierte Basisbereiche 24 erzeugt werden. Die dotierten Basisbereiche 24 auf der Rückseite 14 umfassen eine höhere Dotierstoffkonzentration als die Dotierstoffkonzentration des Halbleitersubstrats 12. Auf der Rückseite 14 diffundiert der Dotierstoff aus der Precursorschicht 26 nicht, oder nur in geringen Mengen, in die hochdotierte Siliziumschicht 20, da die dielektrische Schicht 22 als Diffusionsbarriere gegen den Dotierstoff aus der Precursorschicht 26 dient. Auf der Vorderseite 16 wird durch die Dotierung der Oberfläche gemäß der zweiten Polarität der dotierte Bereich 28 auf der Vorderseite 16 erzeugt. Die Dotierstoffkonzentration des dotierten Bereichs 28 auf der Vorderseite 16 ist höher als die Dotierstoffkonzentration des Halbleitersubstrats 12. Bei dem Hochtemperaturschritt handelt es sich beispielsweise um den Ofendiffusionsschritt zum Aufbringen der Precursorschicht 26. Alternativ kann es sich auch um einen zusätzlichen Hochtemperaturschritt handeln.

Der Hochtemperaturschritt kann beispielsweise so gefahren werden, dass nur ein Teil des zweiten Dotierstoffes aus der Precursorschicht in die Basisbereiche auf der Rückseite diffundiert, so dass sich anschließend vorzugweise noch eine signifikante Menge an Dotierstoff in der Precursorschicht 26 befindet. Der Hochtemperaturschritt kann auch zur Aktivierung des Dotierstoffes in der hochdotierten Schicht 20 dienen.

Figur 2f zeigt das Erzeugen von hochdotierten Basisbereichen 30 in den dotierten Basisbereichen 24, durch lokale Erhöhung der Dotierstoffkonzentration, insbesondere durch Laserbestrahlung. Durch die Laserbestrahlung schmilzt oder verdampft die vorher abgeschiedene Precursorschicht 26 und die Oberfläche auf der Rückseite wird in den bestrahlten Bereichen lokal erhitzt und aufgeschmolzen. Weiterer Dotierstoff aus der Precursorschicht diffundiert an den bestrahlten Bereichen in die Oberfläche und dotiert, nach Abkühlen und Rekristallisation, den bestrahlen Bereich weiter gemäß der zweiten Polarität, sodass die hochdotierten Basisbereiche 30 erzeugt werden. Die Dotierstoffkonzentration in hochdotierten Basisbereichen 30 ist signifikant höher als die Dotierstoffkonzentration des Halbleitersubstrats 12, der dotierten Basisbereiche 24 und dem dotierten Bereich 28 auf der Vorderseite 16. Durch geeignete Wahl der Laserparameter können in den hochdotierten Basisbereichen 30 auch lokal selektiv unterschiedlich hochdotierte Abschnitte erzeugt werden. Weiter ist vorgesehen, dass insbesondere verbliebene Reste der Precursorschicht 26 von der Vorderseite 16 und von der Rückseite 14 entfernt werden. Das Entfernen erfolgt nach der Laserbestrahlung beispielsweise in einem nasschemischen Reinigungsschritt. Vorteilhafterweise werden durch den nasschemischen Reinigungsschritt oder durch einen weiteren nachchemischen Reinigungsschritt auch verbliebene Reste der dielektrische Schicht 22 von der hochdotierten Siliziumschicht 20 entfernt.

Das Verfahren umfasst weiter einen Schritt zum Aufbringen einer zweiten Passivierschicht 32 auf der Rückseite 14 und einer dritten Passivierschicht 34 auf der Vorderseite 16, vgl. Figur 2g. Die Passivierschichten 32, 34 umfassen beispielsweise Siliziumdioxid, Siliziumnitrid, Aluminiumoxid oder einen Schichtstapel aus zwei oder mehreren dielektrischen Schichten. Dabei kann sich die Dicke, Brechungsindex und Zusammensetzung der zweiten Passivierschicht 32 auf der Rückseite 14 von Dicke, Brechungsindex und Zusammensetzung der dritten Passivierschicht 34 auf der Vorderseite 16 unterscheiden. Die Dicken der Passivierschichten 32, 34 sind vorteilhafterweise so optimiert, dass die Reflexion auf der Vorderseite 16 verringert und auf der Rückseite 14 erhöht wird. Die Passivierschichten 32, 34 umfassen vorteilhafterweise eine größere Dicke als die erste Passivierschicht 18. Die Dicke der zweiten Passivierschicht 32 ist vorteilhafterweise größer als 4 nm. Der Hochtemperaturschritt für das Wachsen des thermischen Siliziumdioxids, der Passivierschichten 32, 34 kann auch zur Aktivierung des Dotierstoffes in der hochdotierten Schicht 20 dienen.

Das Verfahren umfasst weiter einen Schritt zum Aufbringen von Elektroden 36 einer ersten Polarität und Elektroden 38 einer zweiten Polarität auf der Rückseite 14 der Solarzelle 10, vgl. Figur 2h. Das Aufbringen der Elektroden 36, 38 kann beispielsweise mittels Siebdruck, Aufdampfen, Sputtern oder galvanischer Abscheidung eines oder mehrerer Metallen oder anderer leitfähiger Schichten erfolgen. Die Elektroden 36, 38 können beispielsweise Silberpaste, Silber/AluminiumPaste, Aluminiumpaste oder reines Aluminium, Kupfer, Zinn, Palladium, Silber, Titan, Nickel oder Schichtstapel oder Legierungen der genannten Metalle oder andere leitfähige Schichten, insbesondere leitfähige Polymere oder Oxide, oder eine Kombination solcher Schichten mit Metallen umfassen. Die Zusammensetzung und der Abscheidungsprozess der Elektroden 36, 38 kann sich für die Elektroden 36, 38 der beiden Polaritäten unterscheiden. Die Elektroden 36, 38 können, insbesondere in einem Hochtemperaturschritt nach dem Siebdrucken, lokal die Passivierschicht 32 durchdringen und, je nach Polarität der Elektroden 36, 38, entweder einen dotierten Basisbereich 24, die hochdotierte Siliziumschicht 20, oder einen hochdotierten Basisbereich 30 kontaktieren. Vorzugsweise kontaktieren die Elektroden 38 der zweiten Polarität nur die hochdotierten Basisbereiche 30 und nicht die dotierten Basisbereiche 24.

Optional kann vor dem Aufbringen der Elektroden 36, 38 die Passivierschicht 32 selektiv, beispielsweise durch Laserbestrahlung, entfernt werden, sodass die Elektroden die hochdotierte Siliziumschicht 20 bzw. die lokal hochdotierten Basisbereiche 30 ausschließlich in den selektiv entfernten Bereichen direkt kontaktieren.

## Patentansprüche

1. Rückseitenkontaktierte Solarzelle (10), umfassend ein Halbleitersubstrat (12), insbesondere einen Siliziumwafer, umfassend eine Vorderseite (16) und eine Rückseite (14), wobei die Solarzelle (10) auf der Rückseite Elektroden (36) einer ersten Polarität und Elektroden (38) einen zweiten Polarität umfasst, wobei die Elektroden (36) der ersten Polarität auf einer hochdotierte Siliziumschicht (20) der ersten Polarität angeordnet sind, wobei die hochdotierte Siliziumschicht (20) auf einer auf dem Halbleitsubstrat angeordneten ersten Passivierschicht (18) angeordnet ist, und die Elektroden (38) der zweiten Polarität das Halbleitersubstrat (12) über hochdotierte Basisbereiche (30) der zweiten Polarität des Halbleitersubstrats (12) direkt elektrisch und mechanisch kontaktieren, **dadurch gekennzeichnet, dass** die hochdotierten Basisbereiche (30) der zweiten Polarität innerhalb dotierter Basisbereiche (24) der zweiten Polarität auf der Rückseite (14) der Solarzelle (10) ausgebildet sind, wobei eine Dotierstoffkonzentration in den hochdotierten Basisbereichen (30) höher ist, als eine Dotierstoffkonzentration in den dotierten Basisbereichen (24), und wobei die Dotierstoffkonzentration in den hochdotierten Basisbereichen (30) höher ist als eine Dotierstoffkonzentration eines dotierten Bereichs (28) auf der Vorderseite (16) der Solarzelle (10).

2. Rückseitenkontaktierte Solarzelle (10) nach Anspruch 1, **dadurch gekennzeichnet, dass** auf nicht durch die Elektroden (36) der ersten Polarität und nicht durch die Elektroden (38) der zweiten Polarität kontaktierten Oberflächenbereichen der Rückseite (14) eine zweite Passivierschicht (32) angeordnet ist, wobei die zweite Passivierschicht dicker ist als die erste Passivierschicht.

3. Verfahren zum Herstellen einer rückseitenkontaktierten Solarzelle nach wenigstens einem der Ansprüche 1 bis 2, wobei ein Halbleitersubstrat (12) der Solarzelle (10), eine, insbesondere polierte oder texturierte, Rückseite (14) und eine, insbesondere texturierte, Vorderseite (16) umfasst, das Verfahren umfassend die folgenden Schritte: Aufbringen einer erste Passivierschicht (18), insbesondere umfassend Siliziumdioxid auf einer Oberfläche der Rückseite (14); Abscheiden einer, insbesondere vollflächigen, hochdotierten Siliziumschicht (20) einer ersten Polarität auf der ersten Passivierschicht (18) auf der Rückseite (14; Aufbringen einer dielektrische Schicht (22) auf der Rückseite (14), Freilegen von Basisbereichen (24) des Halbleitersubstrats auf der Rückseite (14) durch lokales Entfernen der dielektrischen Schicht (22), und der hochdotierten Siliziumschicht (20) der ersten Polarität und der ersten Passivierschicht (18) auf der Rückseite (14); lokales Entfernen eines Teils des Halbleitersubstrats (12) in den Basisbereichen (24); wobei das Verfahren einen Schritt zum Anbringen einer Precursorschicht (26) umfassend einen Dotierstoff, insbesondere Phosphor, auf der Rückseite (14) umfasst, und wobei durch einen Hochtemperaturschritt, in dem der Dotierstoff aus der Precursorschicht (26) in die Basisbereiche (24) auf der Rückseite (14) diffundiert, die Dotierung in den Basisbereichen (24) auf der Rückseite erhöht wird, und dass innerhalb der dotierten Basisbereiche (24) auf der Rückseite (14) hochdotierte Basisbereiche (30) durch lokale Erhöhung der Dotierstoffkonzentration erzeugt werden.

4. Verfahren nach Anspruch 3, **dadurch gekennzeichnet, dass** die erste Passivierschicht (18) auch auf einer Oberfläche der Vorderseite (16) aufgebracht wird.

5. Verfahren nach einem der Ansprüche 3 oder 4, **dadurch gekennzeichnet, dass** Freilegen der Basisbereiche (24) des Halbleitersubstrats auf der Rückseite ein Ätzen der hochdotierten Siliziumschicht (20) der ersten Polarität und/oder der ersten Passivierschicht (18) und/oder eines Teils des Halbleitersubstrats lokal in den Basisbereichen (24) umfasst.

6. Verfahren nach Anspruch 5, **dadurch gekennzeichnet, dass** das Ätzen ein isotropes Ätzen zum Polieren von Bereichen und/oder dass das Ätzen ein anisotropes Ätzen zum Texturieren von Bereichen umfasst.

7. Verfahren nach einem der Ansprüche 3 bis 6, **dadurch gekennzeichnet, dass** der Schritt zum Anbringen einer Precursorschicht (26) umfassend einen Dotierstoff, insbesondere Phosphor, auf der Rückseite (14), auch das Anbringen der Precursorschicht (26) auf der Vorderseite (16), umfasst.

8. Verfahren nach Anspruch 7, **dadurch gekennzeichnet, dass** durch den Hochtemperaturschritt, in dem der Dotierstoff aus der Precursorschicht (26) in die Basisbereiche (24) auf der Rückseite (14) diffundiert, der Dotierstoff aus der Precursorschicht (26) in die Oberfläche der Vorderseite (16) diffundiert und ein dotierter Bereich (28) auf der Vorderseite (16) erzeugt wird.

9. Verfahren nach einem der Ansprüche 3 bis 8, **dadurch gekennzeichnet, dass** innerhalb der dotierten Basisbereiche (24) auf der Rückseite (14) die hochdotierten Basisbereiche (30) durch lokale Erhöhung der Dotierstoffkonzentration durch Laserbestrahlung erzeugt werden

10. Verfahren nach wenigstens einem der Ansprüche 3 bis 9, **dadurch gekennzeichnet, dass** das Verfahren einen Schritt zum Entfernen der Precursorschicht (26), insbesondere Phosphorsilikatglas, von der Vorderseite (16) und/oder von der Rückseite (14) umfasst.

11. Verfahren nach wenigstens einem der Ansprüche 3 bis 10, **dadurch gekennzeichnet, dass** das Verfahren einen Schritt zum Aufbringen einer zweiten Passivierschicht (32) auf der Rückseite (14) und/oder einer dritten Passivierschicht (34) auf der Vorderseite (16) umfasst.

12. Verfahren nach Anspruch 11, **dadurch gekennzeichnet, dass** das Verfahren einen Schritt zum selektiven Entfernen der zweiten Passivierschicht (32) auf der Rückseite (14) umfasst.

13. Verfahren nach wenigstens einem der Ansprüche 3 bis 12, **dadurch gekennzeichnet, dass** das Verfahren einen Schritt zum Aufbringen von Elektroden (36) einer ersten Polarität und Elektroden (38) einer zweiten Polarität auf der Rückseite (14) der Solarzelle (10) umfasst.

## Claims

1. Back-contact solar cell (10) comprising a semiconductor substrate (12), in particular a silicon wafer, comprising a front side (16) and a back side (14), the solar cell (10) comprising electrodes (36) of a first polarity and electrodes (38) of a second polarity on the back side, the electrodes (36) of the first polarity being arranged on a highly doped silicon layer (20) of the first polarity, the highly doped silicon layer (20) being arranged on a first passivation layer (18) arranged on the semiconductor substrate, and the electrodes (38) of the second polarity directly electrically and mechanically contacting the semiconductor substrate (12) via highly doped base regions (30) of the second polarity of the semiconductor substrate (12), **characterized in that** the highly doped base regions (30) of the second polarity are formed within doped base regions (24) of the second polarity on the back side (14) of the solar cell (10), a dopant concentration in the highly doped base regions (30) being higher than a dopant concentration in the doped base regions (24), and the dopant concentration in the highly doped base regions (30) being higher than a dopant concentration of a doped region (28) on the front side (16) of the solar cell (10).

2. Back-contact solar cell (10) according to claim 1, **characterized in that** a second passivation layer (32) is arranged on surface regions of the back side (14) not contacted by the electrodes (36) of the first polarity and not by the electrodes (38) of the second polarity, the second passivation layer being thicker than the first passivation layer.

3. Method for producing a back-contact solar cell according to at least one of claims 1 or 2, a semiconductor substrate (12) of the solar cell (10) comprising an, in particular polished or textured, back side (14) and an, in particular textured, front side (16), the method comprising the following steps: applying a first passivation layer (18), in particular comprising silicon dioxide, to a surface of the back side (14); separation of an, in particular, full-coverage, highly doped silicon layer (20) of a first polarity to the first passivation layer (18) on the back side (14); applying a dielectric layer (22) on the back side (14), exposing base regions (24) of the semiconductor substrate on the back side (14) by locally removing the dielectric layer (22), and the highly doped silicon layer (20) of the first polarity and the first passivation layer (18) on the back side (14); locally removing a portion of the semiconductor substrate (12) in the base regions (24); wherein the method comprises a step for attaching a precursor layer (26) comprising a dopant, in particular phosphorous, on the back side (14) and wherein by a high temperature step, in which the dopant from the precursor layer (26) diffuses into the base regions (24) on the back side (14), the doping is increased in the base regions (24) on the back side, and wherein highly doped base regions (30) are generated by locally increasing the dopant concentration in the doped base regions (24) on the back side (14).

4. Method according to claim 3, **characterized in that** the first passivation layer (18) is also applied to a surface of the front side (16).

5. Method according to claim 3 or claim 4, **characterized in that** exposing the base regions (24) of the semiconductor substrate on the back side comprises etching of the highly doped silicon layer (20) of the first polarity and/or etching of the first passivation layer (18) and/or etching of a portion of the semiconductor substrate, locally in the base regions (24) .

6. Method according to claim 5, **characterized in that** the etching comprises isotropic etching for polishing regions, and/or the etching comprises anisotropic etching for texturing regions.

7. Method according to any of claims 3 to 6, **characterized in that** the step for attaching a precursor layer (26) comprising a dopant, in particular phosphorus, on the back side (14), also comprises attaching the precursor layer (26) on the front side (16).

8. Method according to claim 7, **characterized in that**, by means of the high-temperature step in which the dopant diffuses from the precursor layer (26) into the base regions (24) on the back side (14), the dopant from the precursor layer (26) diffuses into the surface of the front side (16) and a doped region (28) is produced on the front side (16).

9. Method according to any of claims 3 to 8, **characterized in that** the highly doped base regions (30) are produced within the doped base regions (24) on the back side (14) by locally increasing the dopant concentration by laser irradiation.

10. Method according to at least one of claims 3 to 9, **characterized in that** the method comprises a step of removing the precursor layer (26), in particular phosphorus silicate glass, from the front side (16) and/or from the back side (14).

11. Method according to at least one of claims 3 to 10, **characterized in that** the method comprises a step of applying a second passivation layer (32) on the back side (14) and/or a third passivation layer (34) on the front side (16).

12. Method according to claim 11, **characterized in that** the method comprises a step of selectively removing the second passivation layer (32) on the back side (14).

13. Method according to at least one of claims 3 to 12, **characterized in that** the method comprises a step of applying electrodes (36) of a first polarity and electrodes (38) of a second polarity on the back side (14) of the solar cell (10).

## Revendications

1. Cellule solaire (10) à contact arrière, comprenant un substrat semi-conducteur (12), en particulier une plaquette de silicium, comprenant une face avant (16) et une face arrière (14), dans laquelle la cellule solaire (10) comprend, sur la face arrière, des électrodes (36) d'une première polarité et des électrodes (38) d'une deuxième polarité, dans laquelle les électrodes (36) de la première polarité sont disposées sur une couche de silicium hautement dopée (20) de la première polarité, dans laquelle la couche de silicium hautement dopée (20) est disposée sur une première couche de passivation (18) disposée sur le substrat semi-conducteur, et les électrodes (38) de la deuxième polarité entrent directement en contact électriquement et mécaniquement avec le substrat semi-conducteur (12) via des régions de base hautement dopées (30) de la deuxième polarité du substrat semi-conducteur (12), **caractérisée par le fait que** les régions de base hautement dopées (30) de la deuxième polarité sont formées au sein de régions de base dopées (24) de la deuxième polarité sur la face arrière (14) de la cellule solaire (10), dans laquelle une concentration de dopant dans les régions de base hautement dopées (30) est supérieure à une concentration de dopant dans les régions de base dopées (24), et dans laquelle la concentration de dopant dans les régions de base hautement dopées (30) est supérieure à une concentration de dopant d'une région dopée (28) sur la face avant (16) de la cellule solaire (10) .

2. Cellule solaire à contact arrière (10) selon la revendication 1, **caractérisée par le fait qu'**une deuxième couche de passivation (32) est disposée sur des zones de surface de la face arrière (14) qui ne sont pas contactées par les électrodes (36) de la première polarité et non pas par les électrodes (38) de la deuxième polarité, dans laquelle la deuxième couche de passivation est plus épaisse que la première couche de passivation.

3. Procédé de production d'une cellule solaire à contact arrière selon l'une au moins des revendications 1 à 2, dans lequel un substrat semi-conducteur (12) de la cellule solaire (10) comprend une face arrière (14) en particulier polie ou texturée et une face avant (16), en particulier texturée, le procédé comprenant les étapes suivantes consistant à: appliquer une première couche de passivation (18), comprenant en particulier du dioxyde de silicium, sur une surface de la face arrière (14); déposer une couche de silicium hautement dopée (20) d'une première polarité, en particulier sur toute la surface, sur la première couche de passivation (18) sur la face arrière (14); appliquer une couche diélectrique (22) sur la face arrière (14), exposer des régions de base (24) du substrat semi-conducteur sur la face arrière (14) en éliminant localement la couche diélectrique (22), et la couche de silicium hautement dopée (20) de la première polarité et la première couche de passivation (18) sur la face arrière (14); éliminer localement une partie du substrat semi-conducteur (12) dans les régions de base (24); dans lequel le procédé comprend une étape d'application d'une couche de précurseur (26) comprenant un dopant, en particulier du phosphore, sur la face arrière (14), et que, grâce à une étape à haute température dans laquelle le dopant diffuse de la couche de précurseur (26) dans les régions de base (24) sur la face arrière (14), le dopage dans les régions de base (24) sur la face arrière est augmenté, et que des régions de base hautement dopées (30) sont générées au sein des régions de base dopées (24) sur la face arrière (14) en augmentant localement la concentration de dopant.

4. Procédé selon la revendication 3, **caractérisé par le fait que** la première couche de passivation (18) est également appliquée sur une surface de la face avant (16) .

5. Procédé selon l'une quelconque des revendications 3 ou 4, **caractérisé par le fait que** l'exposition des régions de base (24) du substrat semi-conducteur sur la face arrière comprend une gravure de la couche de silicium hautement dopée (20) de la première polarité et/ou de la première couche de passivation (18) et/ou d'une partie du substrat semi-conducteur localement dans les régions de base (24).

6. Procédé selon la revendication 5, **caractérisé par le fait que** la gravure comprend une gravure isotrope pour polir des régions et/ou que la gravure comprend une gravure anisotrope pour texturer des régions.

7. Procédé selon l'une quelconque des revendications 3 à 6, **caractérisé par le fait que** l'étape consistant à appliquer une couche de précurseur (26) comprenant un dopant, en particulier du phosphore, sur la face arrière (14), comprend également l'application de la couche de précurseur (26) sur la face avant (16).

8. Procédé selon la revendication 7, **caractérisé par le fait que**, grâce à l'étape à haute température dans laquelle le dopant diffuse de la couche de précurseur (26) dans les régions de base (24) sur la face arrière (14), le dopant diffuse de la couche de précurseur (26) dans la surface de la face avant (16), et une région dopée (28) est générée sur la face avant (16).

9. Procédé selon l'une quelconque des revendications 3 à 8, **caractérisé par le fait qu'**au sein des régions de base dopées (24) sur la face arrière (14), les régions de base hautement dopées (30) sont générées en augmentant localement la concentration de dopant par irradiation laser.

10. Procédé selon au moins l'une quelconque des revendications 3 à 9, **caractérisé par le fait que** le procédé comprend une étape d'élimination de la couche de précurseur (26), en particulier du verre de phosphosilicate, de la face avant (16) et/ou de la face arrière (14).

11. Procédé selon au moins l'une quelconque des revendications 3 à 10, **caractérisé par le fait que** le procédé comprend une étape d'application d'une deuxième couche de passivation (32) sur la face arrière (14) et/ou d'une troisième couche de passivation (34) sur la face avant (16).

12. Procédé selon la revendication 11, **caractérisé par le fait que** le procédé comprend une étape d'élimination sélective de la deuxième couche de passivation (32) sur la face arrière (14).

13. Procédé selon au moins l'une quelconque des revendications 3 à 12, **caractérisé par le fait que** le procédé comprend une étape d'application d'électrodes (36) d'une première polarité et d'électrodes (38) d'une deuxième polarité sur la face arrière (14) de la cellule solaire (10).
